(19) **Europäisches Patentamt / European Patent Office / Office européen des brevets**

(11) **EP 1 275 750 B1**

(12) # EUROPÄISCHE PATENTSCHRIFT

(45) Veröffentlichungstag und Bekanntmachung des Hinweises auf die Patenterteilung:
**01.07.2009 Patentblatt 2009/27**

(51) Int Cl.:
***C23C 14/30*** *(2006.01)*

(21) Anmeldenummer: **02010092.1**

(22) Anmeldetag: **07.05.2002**

(54) **Bedampfungsanlage**

Vapor deposition apparatus

Appareil pour la métallisation sous vide

(84) Benannte Vertragsstaaten:
**CH DE FR IT LI**

(30) Priorität: **11.07.2001 DE 10133748**

(43) Veröffentlichungstag der Anmeldung:
**15.01.2003 Patentblatt 2003/03**

(73) Patentinhaber: **Carl Zeiss Vision GmbH**
**73430 Aalen (DE)**

(72) Erfinder: **Malischke, Roland**
**89555 Söhnstetten (DE)**

(74) Vertreter: **Braunger, Dieter**
**Carl Zeiss AG**
**Patentabteilung**
**Carl-Zeiss-Straße 22**
**73447 Oberkochen (DE)**

(56) Entgegenhaltungen:

| | |
|---|---|
| **DE-A1- 4 336 680** | **JP-A- 59 041 473** |
| **US-A- 3 432 335** | **US-A- 5 003 151** |
| **US-A- 5 277 938** | **US-B1- 6 214 408** |

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 1 275 750 B1

**Beschreibung**

Die Erfindung betrifft eine Vorrichtung zur Auslenkung eines Elektronenstrahls sowie eine Vakuumbedampfungsanlage mit einer derartigen Vorrichtung und ein Verfahren zum Betrieb derselben.

Durch die Firma Leybold wird unter der Bezeichnung "MDC e-Vap-PSL Programmable Sweep Control" ein Strahlablenkungssystem einer Bedampfungsanlage vertrieben. Bei diesem Strahlablenkungssystem ist es möglich, vor dem Starten des Bedampfungsprozesses den Elektronenstrahlverlauf festzulegen, der während des anschließenden Betriebes der Bedampfungsanlage vom Elektronenstrahl abgefahren werden soll. Im Rahmen dessen ist es möglich, abweichend von den in der Steuerung der Vakuumbedampfungsanlage als Grundausstattung abgespeicherten Verläufen einer Elektronenstrahlablenkung, ein eigenes Muster zu entwerfen, das anschließend vom Elektronenstrahl fortwährend, in sich ständig wiederholender Weise, abgefahren wird.

Nachteilig ist jedoch, daß aufgrund der periodischen Ablenkung des Elektronenstrahls der Abbrand des zu verdampfenden Materials nicht optimal ist, insbesondere in der Mitte am größten ist, so daß der Tiegel mit Verdampfungsmaterial vorzeitig ausgewechselt werden muß, was sich negativ auf die Kosten auswirkt, da es sich bei den eingesetzten Materialien in der Regel um teure Materialien, wie z.B. Gold, handelt. Hinzu kommt, daß eine unsymmetrische Dampfkeule auftreten treten kann.

JP 590 414 73, US 3 432 335, US 5 003 151, US 6 214 408 und DE 4 336 680 offenbaren weitere Strahlablenkungssysteme.

Die Firma BOC Coating Technology vertreibt ein "Temescal Bipolar Sweep" genanntes Strahlablenkungssystem, bei dem die Ablenkung in beiden Koordinatenrichtungen Sinus- oder Dreieckförmig sein kann (mit einstellbarer fester Amplitude und einstellbarem festen Offset). Die beiden Ablenkfrequenzen können verschieden oder auch gleich sein. Nur bei Frequenzgleichheit läuft die Strahlablenkung in beiden Koordinatenrichtungen synchron ab. Es gibt acht voreinstellbare Parametersätze (Amplitude, Frequenz, Offset, jeweils für die X- und die Y-Richtung), zwischen denen während des Bedampfungsvorgangs umgeschaltet werden kann.

Auch mit diesem Gerät kann man den Abbrand auf dem Verdampfungsmaterial nur sehr ungenau kontrollieren, da die Ablenkfunktionen auf Sinus und Cosinus oder auf Dreieckfunktionen festgelegt sind. Es ist lediglich möglich jeweils für jede Koordinatenrichtung Offset, Amplitude, Frequenz einmal einzustellen.

Der Erfindung lag die Aufgabe zugrunde eine Vakuumbedampfungsanlage bereitzustellen, bei der die Symmetrie und die Beständigkeit der Dampfkeule verbessert ist.

Weiterhin lag der Erfindung die Aufgabe zugrunde, die Herstellkosten von dünnen Schichten zu senken, indem der Abbrand auf der Probe gleichmäßiger stattfindet. Weiterhin lag der Erfindung die Aufgabe zugrunde, die Elektronenstrahlauslenkung komfortabler zu gestalten.

Durch die Merkmale in den Ansprüchen 1 und 8 kann ein besonders gleichmäßiger Abbrand eines Verdampfungsmaterials mittels eines Elektronenstrahls gewährleistet werden. Folgedessen bildet sich eine besonders symmetrische Dampfwolke aus, die auch während des Beschichtungsbetriebes durch den gleichmäßigen Abbrand erhalten bleibt.

Eine während des Betriebes gleichbleibende symmetrische Dampfwolke wirkt sich zum einen vorteilhaft auf eine gleichmäßige Schichtdicke auf den zu beschichteten Substraten aus und zum anderen kann in einem Tiegel befindliches Verdampfungmaterial nahezu vollständig aufgebraucht werden, woraus ein Kostenvorteil resultiert. Dieser Kostenvorteil wirkt sich um so deutlicher aus, je teurer die Aufdampfmaterialien sind.

Eine Vorrichtung, mit der ein besonders gleichmäßiger Abbrand erreicht werden kann, konnte durch die Maßnahme, den Elektronenstrahl in zwei Koordinatenrichtungen gemäß ausgewählter Funktionen durch Ansteuerung von Ablenkmodulen auszulenken, realisiert werden.. Durch die Maßnahme, mindestens eine dieser ausgewählten Funktionen mit einem sich zeitlich ändernden Term zu versehen, wurde es möglich, den Elektronenstrahl mit zeitlich sich ändernden Periodizitäten auszulenken. Dies wirkt sich insbesondere vorteilhaft bei Rundungen aufweisenden Tiegelformen aus.

Es hat sich als vorteilhaft herausgestellt den Term, durch den eine zeitlich veränderbare Periodizität vorgebbar einstellbar ist, über eine Eingabeeinheit, insbesondere auch während des Aufdampfprozesses eingeben zu können. Auf diesem Weg kann insbesondere die Verdampfungsrate des Materials und die Form der ausgebildeten Dampfwolke korrigiert werden. Mit solchen Korrekturen können insbesondere Schwankungen der Materialeigenschaften und Materialbeschaffenheit mit geringem Aufwand kompensiert werden.

Durch die Möglichkeit auch während des Aufdampfprozesses Korrekturen, insbesondere auch bezüglich der ausgewählten Funktionen, vornehmen zu können, kann vor allem der Ausschuß verringert werden.

Es hat sich als vorteilhaft herausgestellt, die zeitliche Veränderung programmieren zu können. Damit ist es möglich, speziell auf das Material, Tiegelform usw. abgestimmte Elektronenstrahlauslenkungen generieren zu können, die auch abgespeichert werden können.

Bei dem Verfahren der Elektronenstrahlauslenkung ist es vorteilhaft, die Elektronenstrahlablenkungen in X- und Y-Richtung zeitlich koordiniert, d.h. phasenstarr, ablaufen zu lassen. Diese zeitliche Koordinierung kann z.B. durch ein Triggersignal erreicht werden, indem die Elektronenstrahlauslenkung in Abhängigkeit von dem Triggersignal gesteuert wird.

Zusätzlich kann eine kleine Wobbelung vorgesehen sein. Durch solch eine Wobbelung kann ein besonders gleichmäßiger Abbrand durch die auf die Oberfläche des Verdampfungsmaterials auftreffenden Elektronen erreicht werden.

Erfindungsgemäß laufen die Elektronenstrahlablenkungen in beiden Koordinatenrichtungen unter einer einheitlichen zeitlichen Kontrolle. Die Ablenkfunktionen sind so auszuwählen, daß der Strahl im wesentlichen mit konstanter Geschwindigkeit über die Probe streicht. Im Fall sinusförmiger Ablenkungsfunktionen wird dabei die Frequenz fortlaufend geändert. Die einfachste Variante der Erfindung verwendet für die X- und Y-Ablenkung Funktionen der Art:

$$A(V(t)) * Sin(f*V(t)) \text{ und } A(V(t)) * Cos(f*V(t)),$$

wobei $A(V(t))$ eine Dreiecksfunktion ist und $V(t)$ sich als Produkt einer "Geschwindigkeitsfunktion" $v(t)$ und der Zeit zusammensetzt ($V(t)=t*v(t)$), so daß der Abbrand in der Mitte des Tiegels und am Rand gleichmäßig schnell fortschreitet. In bekannter Weise kann den so beschriebenen Bewegungen eine Wobbelung, d.h, eine kleine höherfrequente Oszillation überlagert sein, so daß man Ungleichmäßigkeiten wegen der größeren Intensität in der Strahlmitte verglichen mit dem Strahlrand weiter ausgleicht. Weiterhin wird die Dampfwolke dadurch so beeinflußt, daß der Niederschlag des Verdampfungsmaterials auf dem zu bedampfenden Substrat noch gleichmäßiger wird.

Eine andere Variante der Erfindung verwendet in X- und Y-Richtung Sinus und Cosinus mit fester Frequenz und einer veränderlichen Amplitude $A(t)$. Dabei wird bei großem $A(t)$ die Strahlintensität vergrößert, so daß der Strahl das Verdampfungsmatrial am Tiegelrand schneller abträgt. Mit solch einem Strahl wird das Niveau im Tiegel bei jedem Überstreichen durch den Elektronenstrahl an jeder Stelle um das gleiche Stück gesenkt, obwohl der Strahl mancher Orts, insbesondere im Randbereich des Tiegels, schneller über das Verdampfungsmaterial streicht.

Wieder eine andere Variante der Erfindung verändert die Fokussierung des Elektronenstrahls abhängig von den Geschwindigkeitskomponenten in X- und Y-Richtung mit dem Ziel, daß das Verdampfungsmaterial gleichmäßig abgetragen wird.

Natürlich kann man auch alle Möglichkeiten miteinander kombinieren:

- Koordinierte Ablenkung des Strahls in beide Koordinatenrichtungen,
- gleichzeitig Änderung der Strahlintensität und der Fokussierung des Elektronenstrahls.

Dies kann alles programmgesteuert durchgeführt werden, so daß das Verdampfungsmaterial gleichmäßig abgetragen wird.

Die Vorrichtung zur Auslenkung eines Elektronenstrahls umfaßt eine Steuereinrichtung, wodurch die dem Elektronenstrahl zugeordnete Ablenkmodule gemäß ausgewählten Funktionen in zwei Koordinatenrichtungen angesteuert werden können. Dadurch kann der Elektronenstrahl in zwei Koordinatenrichtungen in Abhängigkeit von der momentanen Position ausgelenkt werden.

Es hat sich als vorteilhaft herausgestellt, in Abhängigkeit von dem zu verdampfenden Material durch Auswahl der einstellbaren Parameter, insbesondere des hochfrequenten Signalanteils und des zeitlich veränderbaren Terms, die Elektronenstrahlauslenkung einzustellen.

Auch ist es bei der Herstellung von Mehrschichtsystemen möglich, mit dem Wechsel des von dem Elektronenstrahl getroffenen zu verdampfenden Materials gleichzeitig die Auslenkung bzw. die Geschwindigkeit, mit der der Elektronenstrahl über das zu verdampfende Material geführt wird, anzupassen und somit die unterschiedlichen Verdampfungsenergien der Materialien zu berücksichtigen.

Es hat sich als vorteilhaft herausgestellt, die Verdampfungsrate zu detektieren. Dadurch kann zum einem der Zeitpunkt, zu dem das zu verdampfende Material vollständig aufgebraucht ist, exakter bestimmt werden, und zum anderen kann bei Detektion einer Abweichung von der Sollaufdampfrate die Auslenkung des Elektronenstrahls entsprechend der Sollaufdampfrate angepaßt werden.

Weiterhin ist es möglich die Auslenkung des Elektronenstrahls, Schwingungsfunktion oder andere periodische Funktion wie z.B. Dreieck- oder Rechteckfunktion in Abhängigkeit von der Tiegelform durchzuführen.

Vorteilhaft ist außerdem, als Grundfunktion eine periodische Funktion im Bereich von 4-150 Hz auszuwählen.

Weiterhin hat es sich als vorteilhaft herausgestellt, die Elektronenstrahlauslenkung mit einer Wobbelung im Frequenzbereich von 50-500 Hz zu versehen. Als besonderes vorteilhaft hat sich ein Verhältnis von hochfrequenter Wobbelung zur niederfrequenten Grundfrequenz der periodischen Auslenkung von 4 zu 1 erwiesen.

Weitere vorteilhafte Maßnahmen sind in zusätzlichen Unteransprüchen beschrieben. Anhand eines Ausführungsbeispieles wird die Erfindung näher beschrieben.

Graphische Darstellungen:

Figur 1:    Vakuumbedampfungsanlage;

Figur 2:    Tiegel;

Figur 3:    Blockschaltbild der Elektronenstrahlablenkung;

Figur 4:    Darstellung der pragrammierbaren Zählung und

Figur 5:    graphische Darstellung der Elektronenstrahlablenkung bei einem runden Tiegel

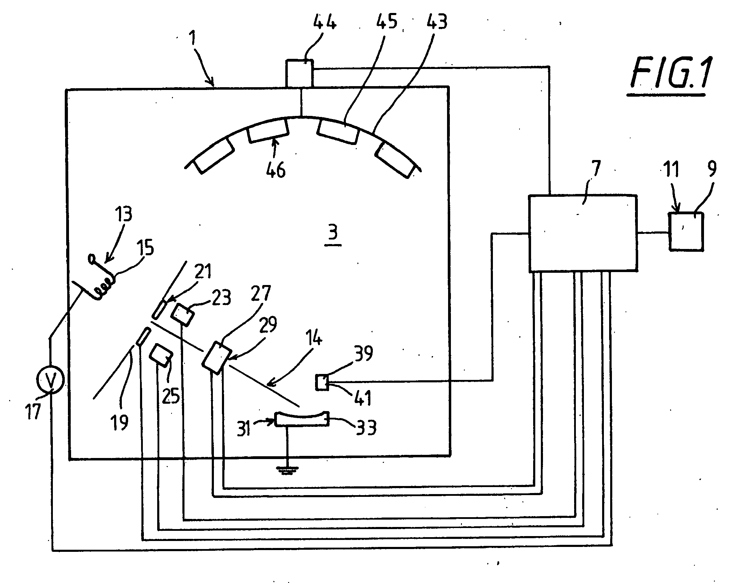

Anhand von Figur 1 wird zunächst der prinzipielle Aufbau einer Vakuumbedampfungsanlage 1 beschrieben. Die in Figur 1 dargestellte Vakuumbedampfungsanlage 1 weist eine Vakuumkammer 3 auf, in der eine Elektronenquelle 13 zur Erzeugung eines Elektronenstrahls 14 angeordnet ist. Als Elektronenquelle 13 ist ein Glühdraht 15 vorgesehen, dem eine Spannungsquelle 17 und ein Gitter 19 zugeordnet sind, so daß durch Anlegen einer Spannung zwischen Glühdraht und Gitter die von 15 emittierten Elektronen in Richtung Gitter 19 beschleunigt werden. Das Gitter ist seinerseits mit einer verstellbaren Blende 21 versehen, so daß die in Richtung Gitter beschleunigten Elektronen durch die Blende fokussiert werden und dadurch der Elektronenstrahl 14 generiert wird.

Für die Ablenkung bzw. Auslenkung des Elektronenstrahls 14 in eine erste Koordinatenrichtung x ist ein erstes Ablenkmodul 23, das Elektromagneten 25 umfaßt, und ein zweites Ablenkmodul 27 für die Auslenkung in eine zweite Koordinatenrichtung y, das die Elektromagneten 29 umfaßt, maßgeblich. Durch ein Steuerprogramm werden die Ablenkungmodule 23, 27 zur gezielten Auslenkung des Elektronenstrahls angesteuert. Das Steuerprogramm wird anhand eines Ausführungsbeispiels mit einem runden Tiegel im folgenden näher beschrieben. Dieses Steuerprogramm ist in einer CPU 101 abgelegt, die Bestandteil einer Steuereinrichtung 7 ist.

Von dieser Steuereinrichtung 7 werden ebenfalls die Einstellung der verstellbaren Blende 21 sowie die Spannung zur Beschleunigung der vom Glühdraht 15 emittierten Elektronen gesteuert.

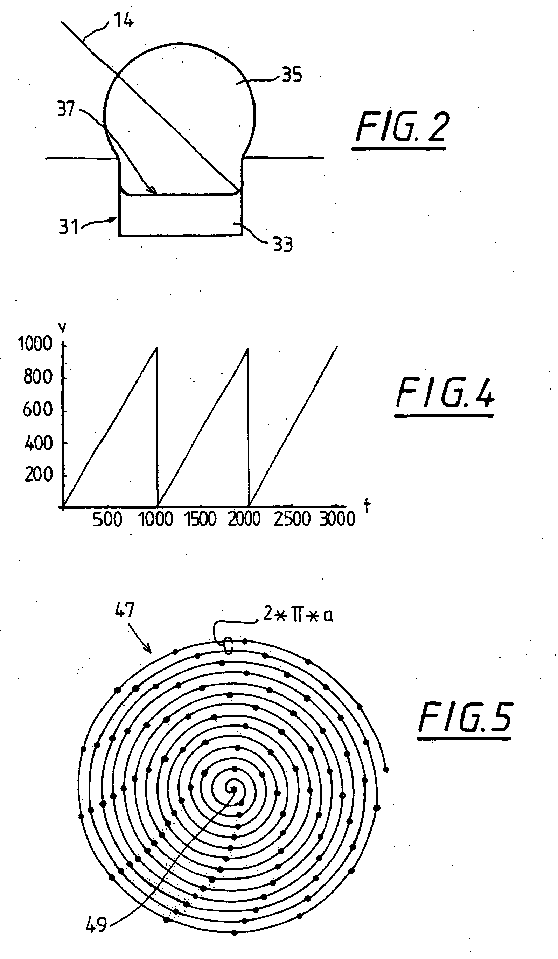

Der Elektronenstrahl 14 ist auf einen Tiegel 31, der mit zu verdampfenden Material 33 gefüllt ist, wie in Figur 2 näher dargestellt, gerichtet. Diesem Tiegel 31 ist ein Detektor 39, wie beispielsweise ein Schwingquarz 41, zur Detektion des verdampften Materials bzw. zur Detektion der Aufdampfrate des Verdampfungsmaterials 33 zugeordnet.

Im oberen Bereich der Vakuumkammer 3 ist eine Kalotte 46 angeordnet, die die zu beschichtenden Substrate 45, wie bzw. Linsen, deren Oberflächen 46 beschichtet werden sollen, trägt. Durch einen zugeordneten Motor 44 ist die Kalotte 46 rotatorisch antreibbar, wobei der Motor durch die Steuereinrichtung 7 angesteuert wird. Der Steuereinrichtung 7 ist eine Bedieneinheit 9, die hier in Form eines Displays 11 ausgestaltet ist, zugeordnet. Über dieses Display 11 können Einstellungen vorgenommen werden, die mittels der Steuereinrichtung 7 ausgeführt werden. Diese Einstellungen können sowohl vor, als auch während dem Aufdampfprozeß vorgenommen werden.

In Figur 2 ist der Tiegel 31, in dem das zu verdampfende Material 33 aufgenommen ist, dargestellt. Das zu verdampfende Material 33 wird mittels des Elektronenstrahls 14 verdampft. Es bildet sich eine Dampfwolke 35 aus. In Abhängigkeit von der Führung des Elektronenstrahls in Bezug auf die Oberfläche des Verdampfungsmaterials wird das Verdampfungsmaterial gleichmäßig abgetragen. Dieser Abtrag wird auch mit Abbrand 37 bezeichnet. Durch den gleichmäßigen Abbrand des Verdampfungsmaterials 33 kann die symmetrische Ausbildung einer Dampfwolke 35 gewährleistet werden.

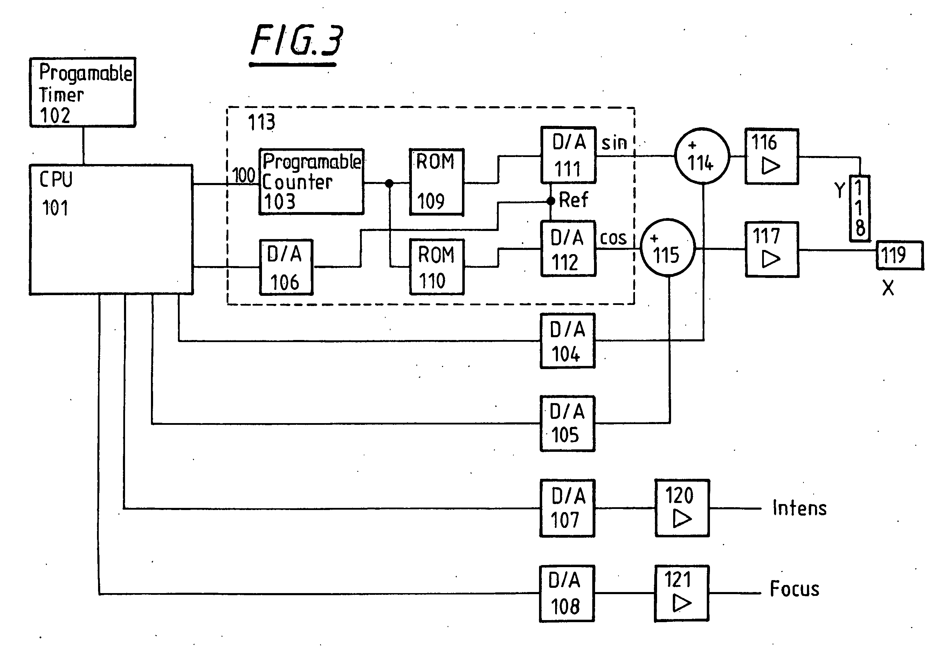

Figur 3 zeigt eine vorteilhafte Ausgestaltung der Steuereinrichtung 7 zur Bereitstellung der erfindungsgemäßen Strahlablenkung. Mittels dieser Steuereinrichtung 7 werden Spannungssignale 118,119 generiert , die an den Ablenkmodulen 23, 27 zur Auslenkung des Elektronenstrahls anliegen. Die Steuereinrichtung 7 beinhaltet einen CPU-Kern 101 mit einen erforderlichen Festwertspeicher, Arbeitsspeicher und Steuerungsprogramm. Der CPU-Kern umfaßt ein ROM und ein RAM. Der CPU-Kern 101 hat Zugriff auf einen programmierbaren Zeitgeber 102, der periodisch Interrupts an den CPU-Kern 101 sendet und darüber hinaus ein höherfrequentes periodisches Signal für einen programmierbaren Zähler 103 bereitstellt. Außerdem sind an den CPU-Kern 101 mehrere Digital-Analogwandler 103-108 angeschlossen. In kurzzeitigen periodischen Intervallen bekommt der CPU-Kern 101 Interrupts von dem programmierbaren Zeitgeber 102 und lädt in Abhängigkeit von den erhaltenen Interrupts neue Ausgabewerte in die beiden Digital-Analogwandler 104, 105. Dadurch wird grob eine Auslenkung des Elektronenstrahls 14 in Y- und X-Richtung gesteuert. Die Ausgabewerte können in einem Speicher abgelegt sein oder mittels abgelegter Funktionen, die in der CPU abgelegt sein können, generiert werden. Als Speicher kann ein im CPU angeordnetes RAM und/oder ROM vorgesehen sein.

Der programmierbare Zähler 103 beinhaltet einen Untersetzer, der dafür sorgt, daß der Zähler 103 bei jedem n-ten, z.B. 1000-sten Impuls, auf dem Clock-Eingang 100 um Eins weiter zählt. Der Untersetzungsfaktor n wird vom CPU-Kern zeitabhängig vorgegeben. Nach Erreichen eines Höchstwerts, z.B. der Zahl 4095, wird der Zähler mit dem nächsten n-ten Clockimpuls wieder auf einen Startwert, vorzugsweise auf Null, zurückgesetzt. Die Zählerausgänge stehen mit ROM-Bausteinen 109,110 in Verbindung, deren Ausgänge jeweils mit nachgeschalteten Digital-Analogwandlern 111, 112 in Signalverbindung stehen.

Über diese Ausgänge der Digital-Analogwandler 111, 112 wird ein Sinus- und ein Cosinussignal ausgegeben. Die Frequenz und Phasenlage dieser ausgegebenen Signale werden über den programmierbaren Zähler 103 aufeinander abgestimmt und sind somit zueinander zu jedem Zeitpunkt koordiniert. Dies wird auch als phasenstarr bezeichnet.

Die Amplitude der Sinus- und Cosinusfunktion wird mittels des Digital-Analogwandlers 106 und über die mit den Digital-Analogwandlern 111, 112 verbundenen Referenzeingängen programmgesteuert eingestellt. Der gesamte Funktionsblock 113 dient dazu, der mittels der beiden Digital-Analogwandler 104, 105 induzierten groben Ablenkung des Elektronenstrahls 14 eine Wobbelung zu überlagern. Der Elektronenstrahl 14 wird gemäß einem generierten Spannungssignal durch die Ablenkmodule 23, 27 ausgelenkt. Selbstverständlich können zur Generierung eines gewobbelten Spannungssignals zur Auslenkung des Elektronenstrahls 14 auch andere periodische Funktionen als Sinus-und Cosinusfunktionen verwendet werden.

Über die Summationsverstärker 114, 115 gehen die beiden Wobbelsignale an zwei Endstufen 116, 117. Die Endstufen 116, 117 erzeugen aus den beiden gewobbelten Eingangsspannungen entsprechende Steuerströme 118, 119, die den Ablenkmodulen 27 zur Auslenkung des Elektronenstrahls in X- und Y-Richtung zugeführt werden.

Außerdem wird mittels des CPU-Kerns 101 über die Digital-Analogwandler 107, 108 mit nachgeschalteten Endstufen 120, 121 die Strahlintensität durch Ansteuerung der Spannungsquelle 17 und die Strahlfokussierung mittels Blende 21 gesteuert.

In diesem Ausführungsbeispiel ist ein Steuerprogramm im CPU-Kern abgelegt, das durch den Interrupt aus dem programmierbaren Zeitgeber 102 periodisch aktiviert wird. Dabei wird die Anzahl der Aufrufe in dem Steuerprogramm in einer Variablen v fortlaufend bis zu einer Höchstzahl m gezählt. Beim danach folgenden Interrupt setzt es den Zähler v zurück auf null. Die Variable v ist also proportional zur Zeit modulo einem Wiederholungsintervall, das in dem in Figur 4 dargestellten Beispiel 1000 Zeiteinheiten beträgt.

Der Elektronenstrahl 14 wird nun gemäß einer archimedischen Spirale 47 über das Verdampfungsmaterial 33 geführt, wobei die Geschwindigkeit so gesteuert wird, daß der Elektronenstrahl 14 in gleichen Zeitintervallen gleiche Weglängen zurücklegt. Die archimedische Spirale 47 ist mathematisch beschreibbar durch:

$$x(rho) = a*rho*Cos(rho+ph), \quad y(rho) = a*rho*Sin(rho+ph)$$

Dabei ist **2*Phi*a** der Abstand von einem Spiralarm zum nächsten, rho ist eine passende Funktion der Zeit und ph ist eine Konstante, mit der man die ganze archimedische Spirale um ihren Mittelpunkt verdrehen kann. Damit die Geschwindigkeit des Elektronenstrahls 14 konstant ist, berechnet der CPU-Kern

$$rho[v] = (Sqrt[2*c*v+ c1]/Sqrt[a]),$$

wobei c und cl numerische Konstanten sind, so daß die Spirale innerhalb einer Wiederholung von v nicht über die Ausdehnung des Tiegels hinausreicht. Sqrt stellt das mathematische Wurzelzeichen dar.

Um die Geschwindigkeitsverhältnisse zu verdeutlichen, ist in Figur 5 die archimedische Spirale 47 dargestellt, die der Elektronenstrahl 14 auf dem Verdampfungssubstrat 33 zurücklegt, wenn der CPU-Kern nach Berechnung von rho[v] die Ausgabewerte x(rho) berechnet und in den Analog-Digitalwandler 104 ablegt und y(rho) in den Analog-Digitalwandler 105 ablegt. In beiden Fällen wird auch noch ein additiver, zeitlich unveränderlicher, Offsetwert berücksichtigt, der die Mittelpunktslage 49 der archimedischen Spirale 47 beeinflußt. Um die Geschwindigkeitsverhältnisse zu verdeutlichen, ist in Figur 5 z.B. jeder 500. Ablenkungswert als dicker Punkt gezeichnet, wobei ein entsprechend großes Wiederholungsintervall von v gewählt worden ist. Wie in Figur 5 zu erkennen ist, haben die Punkte entlang der Kurve gleiche Abstände, was einer konstanten Geschwindigkeit bzgl. des zurückgelegten Weges des abgelenkten Elektronenstrahls 14 und nicht des überstrichenen Winkels entspricht. Die Winkelgeschwindigkeit des Elektronenstrahls ist bei diesem Ausführungsbeispiel gezielt variabel.

Dieses Bild zeigt den prinzipiellen Verlauf des Strahls, wenn die Wobbelung über den Digital-Analogwandler 106 abgeschaltet ist. Wenn die Wobbelung aktiv ist, wird der Spirale eine Kreiselbewegung mit kleiner Amplitude - z.B. in der Größenordnung des Spiralarm-Abstands 2*Phi*a überlagert.

Damit die Spirale nicht jedesmal gleich durchlaufen wird, kann zusätzlich bei jeder Wiederholung von v eine kleine Änderung an der Variablen ph vorgenommen werden. Zusätzlich kann man abwechselnd bei jeder Wiederholung das Vorzeichen von x(rho) oder y(rho) umkehren, wodurch die Spirale in anderer Richtung durchlaufen wird.

Dieses hier detailliert erläuterte Ausführungsbeispiel zeigt eine besonders vorteilhafte Steuerung des Elektronenstrahls 14 für einen runden Tiegel 31. Die Erfindung ist jedoch nicht eingeschränkt auf runde Tiegel 31 zu verstehen. Anstelle der archimedischen Spirale 47 ist eine der verwendeten Tiegelform geeignete Strahlführung auszuwählen. So ist z.B. für einen ovalen Tiegel eine grobe Führung des Elektronenstrahls entlang einer elliptischen Bahn mit sich ändernden Radien geeignet. Wie an der weiteren kurz dargestellten Variation zu erkennen ist, ergibt sich eine Fülle von Variationsmöglichkeiten, die vom Erfindungsgedanken mit umfaßt werden.

Weiterhin ist der CPU 101 ist eine Speichereinheit ROM zugeordnet, in der für verschiedene Verdampfungsmaterialien zugeordnete Werte abgelegt sind, durch die die Geschwindigkeit und die Intensität, mit der der Elektronenstrahl 14 das Verdampfungsmaterial 33 abfährt, abgelegt sind.

Bezugszeichenliste:

| | |
|---|---|
| 1. | Vakuumbedampfungsanlage |
| 2. | Vakuumkammer |
| 7. | Steuereinrichtung |
| 9. | Bedieneinheit |
| 11. | Display |
| 13. | Elektronenquelle |
| 14. | Elektronenstrahl |
| 15. | Glühdraht |
| 17. | Spannungsquelle |
| 19. | Gitter |
| 21. | (verstellbare) Blende |
| 23. | Ablenkmodul |
| 47. | Archimedische Spirale |
| 49. | Mittelpunkt |
| 51. | 500-ster Ablenkwert |
| 100 | clock-Eingang |
| 101 | CPU-Kern |
| 102 | programmierbarer Zeitgeber |
| 103 | programmierbarer Zähler |
| 103 | Digital-/Analogwandler (D/A Wandler) |
| 104 | D/A Wandler |
| 105 | D/A Wandler |
| 106 | D/A Wandler |
| 107 | D/A Wandler |
| 108 | D/A Wandler |
| 109 | ROM |
| 110 | ROM |
| 111 | D/A Wandler |
| 112 | D/A Wandler |
| 113 | Funktionsblock |
| 114 | Summationsverstärker |
| 25. | Elektromagnete |
| 27. | Ablenkmodul |
| 29. | Elektromagnete |
| 31. | Tiegel |
| 33. | Verdampfungsmaterial |
| 35. | Dampfwolke |
| 37. | Abbrand |
| 39. | Detektor |
| 41. | Schwingquarz |
| 43. | Kalotte |
| 44. | Motor |
| 45. | Substrat |
| 46. | Linsenoberfläche |
| 115 | Summationsverstärker |
| 116 | Endstufe |
| 117 | Endstufe |

| 118 | Steuerstrom |
| 119 | Steuerstrom |
| 120 | Endstufe |
| 121 | Endstufe |

**Patentansprüche**

1. Vorrichtung zur Herstellung dünner Schichten in einer Vakuumanlage mit einer Steuereinrichtung zur Auslenkung eines Elektronenstrahls, der Ablenkmodule zugeordnet sind, die gemäß jeweils ausgewählter Funktionen ansteuerbar sind, wobei durch deren Ansteuerung der Elektronenstrahl in zwei Koordinatenrichtungen auslenkbar ist, **dadurch gekennzeichnet, dass** mindestens eine der ausgewählten Funktionen einen sich zeitlich ändernden Term umfaßt, durch den sich die Periodizität der Auslenkung des Elektronenstrahls (14) in mindestens einer Koordinatenrichtung ändert, so dass der Elektronenstrahl mit konstanter Geschwindigkeit bezüglich der zurückgelegten Strecke das abzubrennende Verdampfungsmaterial überstreift.

2. Vorrichtung nach Anspruch 1, **dadurch gekennzeichnet, dass** der Term, durch den der Elektronenstrahl in mindestens eine der Koordinatenrichtungen mit sich zeitlich ändernder Periodizität ausgelenkt wird, mittels einer während des Aufdampfprozesses manuell bedienbaren Eingabeeinheit generiert wird.

3. Vorrichtung nach Anspruch 1, **dadurch gekennzeichnet, dass** der Term, durch den der Elektronenstrahl in mindestens eine der Koordinatenrichtungen mit sich zeitlich ändernder Periodizität ausgelenkt wird, automatisiert durch die Steuereinrichtung vorgegeben wird.

4. Vorrichtung nach Anspruch 2 oder 3, **dadurch gekennzeichnet, dass** der Term einen programmierbaren, zeitlich veränderbaren Faktor umfaßt.

5. Vorrichtung nach Anspruch 2 oder 3, **dadurch gekennzeichnet, dass** mindestens eine der ausgewählten Funktionen einen zeitlich veränderbaren Amplitudenterm umfaßt.

6. Vorrichtung nach einem der vorangegangenen Ansprüche 1-5, **dadurch gekennzeichnet, dass** der Term für die zeitlich veränderbare Auslenkung jeweils von dem Verdampfungsmaterial abhängig festgelegt ist.

7. Vorrichtung nach mindestens einem der vorangegangenen Ansprüche, **dadurch gekennzeichnet, dass** die Intensität des Elektronenstrahls (14) variierbar ist.

8. Verfahren zur Herstellung dünner Schichten in einer Vakuumanlage, bei der ein Elektronenstrahl in zwei Koordinatenrichtungen ausgelenkt wird, **dadurch gekennzeichnet, dass** der Elektronenstrahl (14) in mindestens einer Koordinatenrichtung mit einer sich zeitlich ändernden Periodizität ausgelenkt wird, so dass der Elektronenstrahl mit konstanter Geschwindigkeit bezüglich der zurückgelegten Strecke das abzubrennende Verdampfungsmaterial überstreift.

9. Verfahren nach Anspruch 8, **dadurch gekennzeichnet, dass** der Elektronenstrahl in mindestens einer Koordinatenrichtung mit sich zeitlich ändernder Amplitude ausgelenkt wird.

10. Verfahren nach mindestens einem der vorangegangen Verfahrensansprüche, **dadurch gekennzeichnet, dass** die Auslenkung des Elektronenstrahls in die unterschiedlichen Koordinatenrichtungen mit unterschiedlicher Geschwindigkeit erfolgt, wobei einer niederfrequenten Grundauslenkung, eine hochfrequente, als Wobbelung bezeichnete Auslenkung, überlagert wird.

11. Verfahren nach einem der vorangegangenen Verfahrensansprüche, dass die zeitliche Änderung von Periodizität und/oder Amplitude in Abhängigkeit von der momentanen Position des Elektronenstrahls abhängig gesteuert wird.

12. Verfahren nach Anspruch 10, **dadurch gekennzeichnet, dass** die Frequenz der Grundauslenkung im Bereich von 4 - 150 Hz liegt.

13. Verfahren nach Anspruch 10, **dadurch gekennzeichnet, dass** die Frequenz der Wobbelung im Bereich von 50-500 Hz liegt.

**14.** Verfahren nach einem der vorangegangenen Verfahrensansprüche, **dadurch gekennzeichnet, dass** die Strahlintensität variiert wird.

**15.** Computerprogramm zum Betreiben einer Vakuumbedampfungsanlage durch das die Auslenkung eines Elektronenstrahls gemäß dem Verfahren nach einem der Ansprüche 8-14 gesteuert wird.

**16.** Vakuumverdampfungsanlage, die gemäß einem der vorangegangenen Verfahrensansprüche betreibbar ist.

**Claims**

**1.** Apparatus for producing thin layers in a vacuum system with a control device for deflecting an electron beam which is assigned deflection modules which can be driven in accordance with respectively selected functions, it being possible to deflect the electron beam in terms of two coordinate directions by driving said modules, **characterized in that** at least one of the selected functions comprises a temporally changing term which changes the periodicity of the deflection of the electron beam (14) in at least one coordinate direction such that the electron beam sweeps the evaporation material to be burned off at constant speed with reference to the distance covered.

**2.** Apparatus according to Claim 1, **characterized in that** the term by means of which the electron beam is deflected in at least one of the coordinate directions with a temporally changing periodicity is generated by means of an input unit which can be operated manually during the vapour deposition process.

**3.** Device according to Claim 1, **characterized in that** the term by means of which the electron beam is deflected in at least one of the coordinate directions with a temporally changing periodicity is prescribed in an automated fashion by the control device.

**4.** Apparatus according to Claim 2 or 3, **characterized in that** the term comprises a programmable, temporally variable factor.

**5.** Apparatus according to Claim 2 or 3, **characterized in that** at least one of the selected functions comprises a temporally variable amplitude term.

**6.** Apparatus according to one of the preceding Claims 1 - 5, **characterized in that** the term for the temporally variable deflection is defined as a function of the evaporation material in each case.

**7.** Apparatus according to at least one of the preceding claims, **characterized in that** the intensity of the electron beam (14) is variable.

**8.** Method for producing thin layers in a vacuum system in which an electron beam is deflected in two coordinate directions, **characterized in that** the electron beam (14) is deflected in at least one coordinate direction with a temporally changing periodicity such that the electron beam sweeps the evaporation material to be burned off at constant speed with reference to the distance covered.

**9.** Method according to Claim 8, **characterized in that** the electron beam is deflected in at least one coordinate direction with a temporary changing amplitude.

**10.** Method according to at least one of the preceding method claims, **characterized in that** the deflection of the electron beam in different coordinate directions is performed at different speeds, a high frequency deflection denoted as wobble being superimposed on a low frequency base deflection.

**11.** Method according to one of the preceding method claims, **characterized in that** the temporal change in periodicity and/or amplitude is controlled as a function of the instantaneous position of the electron beam.

**12.** Method according to Claim 10, **characterized in that** the frequency of the base deflection is in the range of 4 - 150 Hz.

**13.** Method according to Claim 10, **characterized in that** the frequency of the wobble is in the range of 50 - 500 Hz.

**14.** Method according to one of the preceding method claims, **characterized in that** the beam intensity is varied.

15. Computer program for operating a vacuum vapour deposition unit by means of which the deflection of an electron beam is controlled in accordance with the method according to one of Claims 8 - 14.

16. Vacuum vapour deposition units which can be operated in accordance with one of the preceding method claims.

**Revendications**

1. Dispositif pour la réalisation de couches minces dans une installation à vide avec un équipement de commande pour la déflexion d'un faisceau électronique, auquel sont assignés des modules de déviation qu'on peut respectivement commander selon des fonctions choisies, leur commande permettant la déflexion du faisceau électronique dans deux directions de coordonnées, **caractérisé en ce qu'**une au moins des fonctions choisies comporte un terme évoluant dans le temps, permettant de modifier la périodicité de la déflexion du faisceau électronique (14) dans au moins une direction de coordonnées de telle sorte que le faisceau électronique balaie le matériau de vaporisation à brûler à une vitesse constante par rapport au parcours effectué.

2. Dispositif selon la revendication 1, **caractérisé en ce que** le terme permettant la déflexion du faisceau électronique dans une au moins des directions de coordonnées avec une périodicité évoluant dans le temps, est généré au moyen d'une unité de saisie utilisable manuellement pendant le processus de métallisation sous vide.

3. Dispositif selon la revendication 1, **caractérisé en ce que** le terme permettant la déflexion du faisceau électronique dans une au moins des directions de coordonnées, avec une périodicité évoluant dans le temps, est défini de manière automatisée par l'équipement de commande.

4. Dispositif selon la revendication 2 ou 3, **caractérisé en ce que** le terme comporte un facteur programmable modifiable dans le temps.

5. Dispositif selon la revendication 2 ou 3, **caractérisé en ce qu'**une au moins des fonctions choisies comporte un terme d'amplitudes modifiable dans le temps.

6. Dispositif selon une des revendications précédentes 1 - 5, **caractérisé en ce que** le terme pour la déflexion modifiable dans le temps est défini respectivement en fonction du matériau de vaporisation.

7. Dispositif selon une au moins des revendications précédentes, **caractérisé en ce qu'**on peut faire varier l'intensité du faisceau électronique (14).

8. Procédé pour la réalisation de couches minces dans une installation à vide dans lequel on assure la déflexion d'un faisceau électronique dans deux directions de coordonnées, **caractérisé en ce qu'**on assure la déflexion du faisceau électronique (14) dans au moins une direction de coordonnées avec une périodicité évoluant dans le temps, de telle sorte que le faisceau électronique balaie le matériau de vaporisation à brûler à une vitesse constante par rapport au parcours effectué.

9. Procédé selon la revendication 8, **caractérisé en ce qu'**on assure la déflexion du faisceau électronique dans au moins une direction de coordonnées avec une amplitude évoluant dans le temps.

10. Procédé selon une au moins des revendications précédentes du procédé, **caractérisé en ce que** la déflexion du faisceau électronique dans les différentes directions de coordonnées est assurée à une vitesse variable, une déflexion à haute fréquence désignée par vobulation étant superposée à une déflexion de base à basse fréquence.

11. Procédé selon une au moins des revendications précédentes du procédé, **caractérisé en ce qu'**on commande l'évolution relative de la périodicité et/ou de l'amplitude en fonction de la position momentanée du faisceau électronique.

12. Procédé selon la revendication 10, **caractérisé en ce que** la fréquence de la déflexion de base se situe dans la plage de 4 - 150 Hz.

13. Procédé selon la revendication 10, **caractérisé en ce que** la fréquence de la vobulation se situe dans la plage de 50 - 500 Hz.

**14.** Procédé selon une des revendications précédentes du procédé, **caractérisé en ce qu'**on fait varier l'intensité du faisceau.

**15.** Programme d'ordinateur pour exploiter une installation pour la métallisation sous vide, commandant la déflexion d'un faisceau électronique selon le procédé d'une des revendications 8 - 14.

**16.** Installation pour la métallisation sous vide, pouvant être exploitée selon une des revendication précédentes du procédé.

FIG.1

_FIG. 2_

_FIG.4_

_FIG.5_

*FIG.3*

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 59041473 B
- US 3432335 A
- US 5003151 A
- US 6214408 B
- DE 4336680